# EUROPÄISCHE PATENTANMELDUNG

(11) **EP 1 714 727 A2**
(43) Veröffentlichungstag der Anmeldung: **25.10.2006**
(21) Anmeldenummer: 06005713.0
(22) Anmeldetag: 21.03.2006
(51) Int. Cl.: B23K 3/06, B23K 1/00

(54) **Verfahren zum Aufbringen von Lot und Vorrichtung hierfür**

(30) Priorität: 20.04.2005 DE 102005018413
(71) Anmelder: Behr GmbH & Co. KG, 70469 Stuttgart (DE)
(72) Erfinder: Ensminger, Steffen, Dipl.-Ing., 73274 Notzingen (DE); Kämmerer, Martin, Dipl.-Ing., 74321 Bietigheim-Bissingen (DE)
(74) Vertreter: Grauel, Andreas

(57) **Zusammenfassung**

Die Erfindung betrifft ein Verfahren zum Aufbringen von Lot in Form einer Lotpaste (2) auf einer Oberfläche eines Teiles, insbesondere einer nur bereichsweise zu beschichtenden Oberfläche, wobei die Lotpaste (2) mit mindestens einer Walze (4) aufgebracht wird, und eine hierfür geeignete Vorrichtung.

## Beschreibung

Die Erfindung betrifft ein Verfahren zum Aufbringen von Lot in Form einer Lotpaste auf einer Oberfläche eines Teiles gemäß dem Oberbegriff des Anspruchs 1.

Das Aufbringen von Lot auf Oberflächen erfolgt üblicherweise mittels Sprühen. Hierbei wird relativ viel Lot verbraucht, da auch - beispielsweise bei Wellrippenblechen für Wärmeübertrager - Bereiche mit Lot besprüht werden, die nicht in Kontakt mit benachbarten Rohren o.ä. sind. Zur lokalen Beschichtung mit Lot sind Siebdruckverfahren bekannt, die jedoch relativ langsam und teuer sind. So ist beim Siebdruckverfahren für jede Struktur ein extra Sieb anzufertigen.

Aus der DE 37 26 072 C2 ist ein Verfahren zum Auftragen von Lotmaterial auf Folien bekannt, gemäß dem zum Verbinden von Halbzeugen zur Herstellung von Filtern, Katalysatorträgern, Wärmetauschern und Rußfiltern aus wellig geprägten Folien aus hitzebeständigem Edelstahl, welcher (in Gew.-%) 8 bis 28% Chrom, 0 bis 11 % Aluminium, 0 bis 2 % Silizium, 0 bis 3% Kobalt und/oder Mangan, 0 bis 1 % Titan und/oder Zirkonium und/oder Niob und/oder Hafnium sowie die in Edelstählen üblichen Beimengungen und Verunreinigungen enthält, wobei die Wellenberge mit Hilfe eines Reibvorgangs mit Eisen oder mit einem edleren Metall als Eisen oder einer Legierung, die eines oder mehrere der genannten Metalle überwiegend enthält, im Mittel bis zu 5 µm dick belotet werden, die Filter bzw. Träger zusammengefügt und anschließend im Vakuum oder Schutzgas verlötet werden. Hierbei werden bevorzugt mikrokristallin erstarrte Metallfolien verwendet. Dieses Verfahren lässt jedoch noch Wünsche offen.

Es ist daher Aufgabe der Erfindung, ein verbessertes Verfahren zur Verfügung zu stellen, mit dessen Hilfe bei möglichst geringem Lotverbrauch die zu verlötenden Flächen mit Lot versehen werden können.

Diese Aufgabe wird gelöst durch ein Verfahren mit den Merkmalen des Anspruchs 1. Vorteilhafte Ausführungen sind Gegenstand der Unteransprüche.

Erfindungsgemäß wird Lot in der Form einer Lotpaste auf einer Oberfläche eines Teiles, insbesondere einer nur bereichsweise zu beschichtenden Oberfläche, vorgesehen, wobei die Lotpaste mit mindestens einer Walze aufgebracht wird. Durch das Aufbringen der Lotpaste mit Hilfe einer Walze kann sichergestellt werden, dass beispielsweise bei strukturierten Teilen, wie Turbulenzeinlagen, Wellrippenblechen usw. nur die erhabenen Bereiche beschichtet werden, die beim Löten in Kontakt zum Fügepartner stehen, so dass im Vergleich zum Aufsprühen von Lot deutlich weniger Lot erforderlich ist.

Die Lotpaste wird bevorzugt durch eine sich entgegen der Bewegungsrichtung des zu beschichtenden Teils drehende Walze aufgebracht oder die Drehgeschwindigkeit der Walze ist geringer als die Transportgeschwindigkeit des zu beschichtenden Teils, so dass sich eine Relativbewegung zwischen Walze und Teil ergibt. Alternativ ist jedoch auch eine Relativbewegung ohne Verschiebung, d.h. eine Art Abrollen der Walze, möglich, jedoch ergeben die gegenläufigen Bewegungen eine bessere und gleichmäßigere Lotpastenverteilung.

Das Teil wird vorzugsweise mittels einer Zwangsführung entlang der Walze geführt. Die Zwangsführung kann beispielsweise mittels eines Förderbandes oder mittels einer weiteren Walze erfolgen. Andere Zwangsführungen sind möglich.

Um eine möglichst gleiche Verteilung der Lotpaste zu gewährleisten, wird die Lotpaste auf der Walze bevorzugt mittels eines Abstreifers gleichmäßig verteilt, so dass eine gleichmäßig dicke Lotpastenschicht auf der Walze vorliegt, die auf das Teil übertragen wird. Zur Einstellung der Lotpastenschichtdicke auf der Walze lässt sich der Abstreifer bevorzugt in seiner Position zur Walze einstellen, wobei die Einstellung auch während des Beschichtens erfolgen kann, so dass beispielsweise zeitweise keine Lotpaste auf einem Teil des Walzenumfangs vorhanden ist, oder eine besonders dünne Lotpastenschicht vorliegt.

Bevorzugt erfolgt eine gleichzeitige beidseitige Beschichtung des Teils mit Lotpaste mittels zweier Walzen mit gleicher oder unterschiedlicher Drehgeschwindigkeit. Diese haben vorzugsweise eine unterschiedliche Drehrichtung, insbesondere bevorzugt gegenläufig zur Bewegungsrichtung des Teils, um eine möglichst gleichmäßige Lotschichtdicke auf dem Teil zu ermöglichen.

Gemäß einer Variante erfolgt eine Beschichtung des Teils mit Lotpaste mittels einer einzigen Walze.

Die Lotpaste ist bevorzugt eine Nickelbasislotpaste oder weist Nickelbasislotpulver auf.

Bevorzugt wird die Erfindung eingesetzt bei der Herstellung von gelöteten Wärmetauschern, insbesondere für Kraftfahrzeuge, beispielsweise von Abgaswärmetauschern, Ölkühlern oder Ladeluftkühlern.

Im Folgenden wird die Erfindung anhand eines Ausführungsbeispiels mit einer Variante unter Bezugnahme auf die Zeichnung im Einzelnen erläutert. In der Zeichnung zeigen:
- Fig. 1: eine schematische Ansicht einer ersten Vorrichtung zum Aufbringen von Lot,
- Fig. 2: eine schematische Ansicht einer zweiten Vorrichtung zum Aufbringen von Lot, und
- Fig. 3a-3f: mehrere Varianten aufgebrachter Muster.

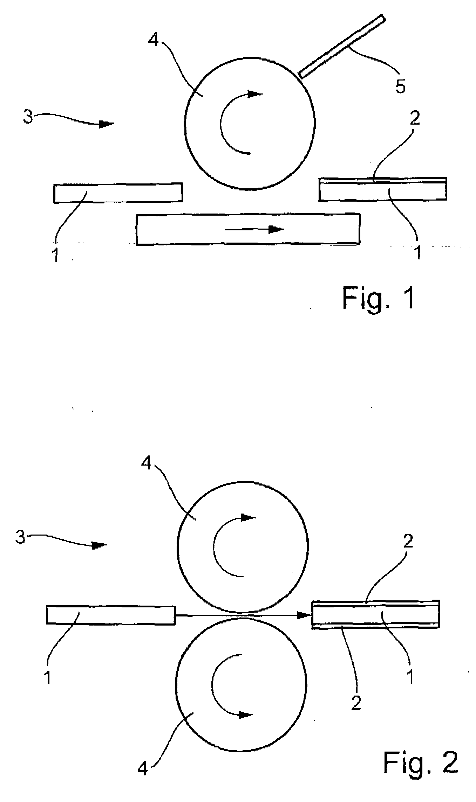

In Fig. 1 ist schematisch der Aufbringungsvorgang dargestellt, bei dem auf einem Teil, vorliegend einem Blech 1 aus Edelstahl, auf einer Seite eine Lotpaste 2 aufgebracht wird. Als Lotpaste 2 wird vorliegend ein Nickelbasislot in Verbindung mit einem Bindersystem verwendet. Andere Lote, insbesondere Kupfer-Nickel-Lote, in Verbindung mit entsprechenden Bindersystemen sind ebenfalls möglich.

Die Beschichtung mit der Lotpaste 2 erfolgt mittels einer Lotpastenaufbringungs-Vorrichtung 3, die eine Walze 4 aufweist, welche sich, wie durch Pfeile dargestellt, gegenläufig dreht, d.h. entgegen der Bewegungsrichtung des Blechs 1. Das Blech 1 wird mittels einer Zwangsführung durch die Vorrichtung 3 gezogen und/oder geschoben. Die Zwangsführung erfolgt vorliegend durch ein entsprechend ausgebildetes, in Fig. 1 stark schematisiert unterhalb der Walze 4 angedeutetes Förderband, welches die Bleche 1 gegen ein Verschieben sichernd mitnimmt. Alternativ ist zur Förderung eine zweite Walze möglich.

Die Walze 4 wird auf bekannte Weise mit flüssiger Lotpaste 2 versehen, wobei mit Hilfe eines Abstreifers 5 in Form eines Rakels die Schichtdicke der Lotpaste 2 auf der Walze 4 gleichmäßig eingestellt werden kann. Der Abstreifer kann beispielsweise auch als Walze ausgebildet sein.

Der Abstreifer 5 kann auch mit Hilfe einer regelbaren Verstellvorrichtung (nicht dargestellt) verstellbar sein, so dass die Schichtdicke der Lotpaste 2 temporär variierbar ist, wodurch beispielsweise die Lotpaste 2 auch vollständig abgestreift werden kann, so dass einzelne Bereiche des Blechs 1 nicht beschichtet werden. Ebenfalls ist gegebenenfalls auch eine dünnere oder dickere Beschichtung möglich. Der Abstreifer 5 kann auch derart ausgebildet sein, dass er die Lotpaste 2 nur an einem Teil der Walze 4 (in Längsrichtung derselben gesehen) entfernt und/oder in ihrer Schichtdicke regelt. Dabei können mehrere derartige Abstreifer 5 über die Länge der Walze 4 verteilt vorgesehen sein.

Die Walze 4 besteht vorliegend aus Stahl, jedoch kann - in Abhängigkeit von dem zu beschichtenden Teil und der Lotpaste - beispielsweise auch eine gummierte Walze vorgesehen sein. Ferner sind Texturen, Konturen, Prägungen, Gravuren usw. möglich, welche die Walzenoberfläche und somit auch den Lotauftrag entsprechend verändern, so dass insbesondere auch nur ein Teil der erhabenen Bereiche oder auch ein ebenes Blech an einzelnen Bereichen beschichtet werden kann.

Um beide Seiten zu beschichten, kann das zu beschichtende Teil umgedreht werden und die gleiche Vorrichtung 3 nochmals durchlaufen. Alternativ kann auch eine gleichzeitige Aufbringung von Lotpaste 2 auf zwei einander gegenüberliegenden Oberflächen des Blechs 1 erfolgen, wie schematisch in Fig. 2 dargestellt. Auch in diesem Fall drehen sich die Walzen 4 entgegen der Bewegungsrichtung des Blechs 1, wie durch Pfeile angedeutet.

Gemäß einer Variante dreht sich die Walze in Bewegungsrichtung des Blechs, jedoch unterscheiden sich die Bewegungsgeschwindigkeit des Blechs und die Umgangsgeschwindigkeit der Walze, so dass auch in diesem Fall die Walzenoberfläche momentan betrachtet relativ und im Wesentlichen parallel zur Blechoberfläche bewegt. Dabei kann die Umfangsgeschwindigkeit der Walze größer oder kleiner als die Bewegungsgeschwindigkeit des Blechs sein.

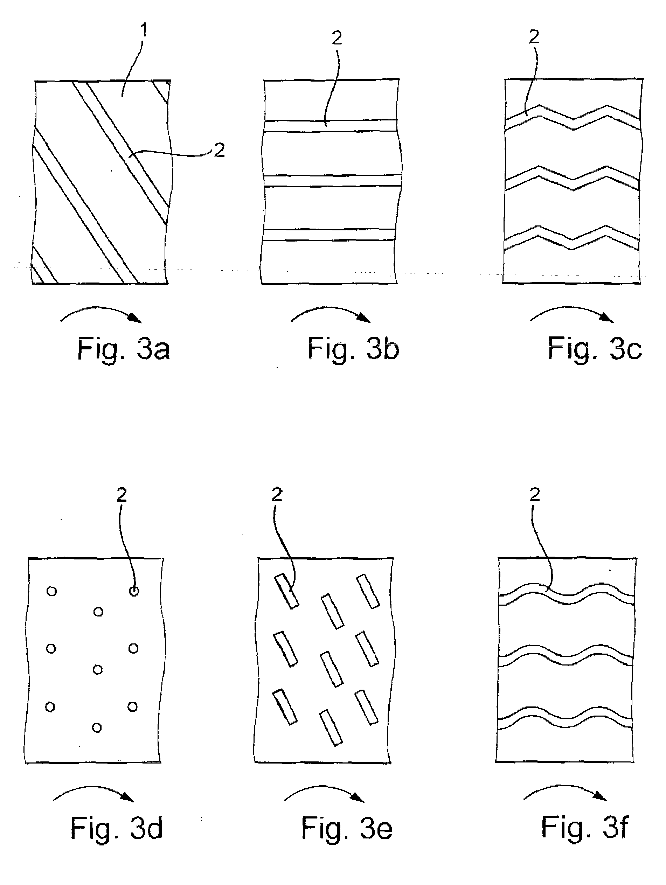

Gemäß einer weiteren Variante entsprechen sich die Bewegungsgeschwindigkeit des Blechs und die Umfangsgeschwindigkeit der Walze. Insbesondere in diesem Fall kann der Abstreifer 5 (vgl. Fig. 1) so gesteuert werden, dass beispielsweise die Beschichtungsmuster der Figuren 3a bis 3f möglich sind. Alternativ wird die Lotpaste entsprechend auf dem Umfang der Walze aufgetragen. Entsprechende Muster, insbesondere gemäß Fig. 3b, sind auch bei einer Relativbewegung zwischen Walze und Blech möglich, erfordern aber eine bessere Abstimmung der Bewegungen.

Weitere Parameter, weiche den Lotauftrag beeinflussen, sind insbesondere die Walzengeschwindigkeit (Relativgeschwindigkeit gegenüber dem Teil), der Abstand der Walze vom Teil und die Lotpastendicke auf der Walze, die insbesondere auch vom Abstreifer abhängt.

## Patentansprüche

1. Verfahren zum Aufbringen von Lot in Form einer Lotpaste (2) auf eine Oberfläche eines Teiles, insbesondere einer nur bereichsweise zu beschichtenden Oberfläche, **dadurch gekennzeichnet, dass** die Lotpaste (2) mit mindestens einer Walze (4) aufgebracht wird.

2. Verfahren nach Anspruch 1, **dadurch gekennzeichnet, dass** die Lotpaste (2) ausschließlich auf erhabenen Bereichen der Oberfläche aufgebracht wird.

3. Verfahren nach Anspruch 1 oder 2, **dadurch gekennzeichnet, dass** die die Lotpaste (2) aufbringende Walze (4) sich entgegen der Bewegungsrichtung der zu beschichtenden Oberfläche dreht.

4. Verfahren nach einem der vorhergehenden Ansprüche, **dadurch gekennzeichnet, dass** das Teil mittels eine Zwangsführung entlang der Walze (4) geführt wird.

5. Verfahren nach einem der vorhergehenden Ansprüche, **dadurch gekennzeichnet, dass** die Lotpaste (2) auf der Walze (4) mittels eines Abstreifers (5) gleichmäßig verteilt wird.

6. Verfahren nach Anspruch 5, **dadurch gekennzeichnet, dass** der Abstreifer in seiner Position zur Walze (4) in Abhängigkeit der Position des zu beschichtenden Teils bewegt wird.

7. Verfahren nach einem der vorhergehenden Ansprüche, **dadurch gekennzeichnet, dass** in Bewegungsrichtung des Teils gesehen nur ein sich ändernden Bereich des Teils beschichtet wird, wofür Lotpaste (2) auf sich ändernden Umfangsbereichen der Walze (4) aufgetragen und/oder mit Hilfe eines oder mehrerer Abstreifer (5) abgestreift wird.

8. Verfahren nach einem der vorhergehenden Ansprüche, **dadurch gekennzeichnet, dass** eine gleichzeitige beidseitige Beschichtung des Teils mit Lotpaste (2) mittels zweier Walzen (4) erfolgt.

9. Verfahren nach Anspruch 8, **dadurch gekennzeichnet, dass** die beiden Walzen (4) unterschiedliche Drehrichtungen haben.

10. Vorrichtung zur Durchführung eines Verfahrens zum Aufbringen von Lotpaste (2) auf einer Oberfläche eines Teils, **dadurch gekennzeichnet, dass** die Vorrichtung mindestens eine Walze (4) aufweist.

11. Vorrichtung nach Anspruch 10, **dadurch gekennzeichnet, dass** die Walze (4) eine Stahlwalze oder eine gummierte Walze ist.

12. Vorrichtung nach Anspruch 10 oder 11, **dadurch gekennzeichnet, dass** die Walze (4) eine strukturierte Walzenoberfläche aufweist.

13. Vorrichtung nach einem der Ansprüche 10 bis 12, **dadurch gekennzeichnet, dass** die Vorrichtung (3) einen Abstreifer (5) aufweist.

14. Vorrichtung nach Anspruch 13, **dadurch gekennzeichnet, dass** der Abstreifer (5) regelbar ist.

15. Vorrichtung nach einem der Ansprüche 10 bis 14, **dadurch gekennzeichnet, dass** die Vorrichtung (3) mindestens zwei Walzen (4) aufweist, die einander gegenüberliegend angeordnet sind, wobei das ein- oder beidseitig zu beschichtende Teil zwischen den beiden Walzen (4) durchführbar ist.

16. Vorrichtung nach einem der Ansprüche 10 bis 15, **dadurch gekennzeichnet, dass** die norrnale Walzendrehrichtung gegenläufig zur Transportrichtung des zu beschichtenden Teils ist.
